(19) Europäisches Patentamt
European Patent Office
Office européen des brevets

(11) **EP 2 312 832 B1**

(12) # FASCICULE DE BREVET EUROPEEN

(45) Date de publication et mention de la délivrance du brevet:
**04.06.2014 Bulletin 2014/23**

(51) Int Cl.:
***H04N 5/3745*** *(2011.01)* ***H04N 5/378*** *(2011.01)*
***H04N 5/365*** *(2011.01)*

(21) Numéro de dépôt: **10179426.1**

(22) Date de dépôt: **24.09.2010**

(54) **Circuit de pixel de capteur d'image**

Pixelschaltung in Bildsensor

Pixel circuit in image sensor

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **24.09.2009 FR 0956600**

(43) Date de publication de la demande:
**20.04.2011 Bulletin 2011/16**

(73) Titulaires:
- **STmicroelectronics SA**
  **92120 Montrouge (FR)**
- **STMicroelectronics (Crolles 2) SAS**
  **38920 Crolles (FR)**

(72) Inventeurs:
- **Barbier, Frédéric**
  **38000, GRENOBLE (FR)**
- **Roy, François**
  **38180, SEYSSINS (FR)**

(74) Mandataire: **Thibon, Laurent et al**
**Cabinet Beaumont**
**1, rue Champollion**
**38000 Grenoble (FR)**

(56) Documents cités:
**US-A- 6 127 857**
**US-A1- 2002 196 352**
**US-A1- 2004 036 009**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 312 832 B1

## Description

Domaine de l'invention

La présente invention concerne un capteur d'image et plus particulièrement le circuit de pixel d'un capteur d'image et un procédé de fabrication de celui-ci.

Exposé de l'art antérieur

Des capteurs d'images monolithiques comprennent des photodiodes et des transistors formés dans un substrat de silicium. Plus particulièrement, ces capteurs d'images comprennent un réseau de pixels dont chacun comprend une photodiode couplée à un noeud de détection par l'intermédiaire d'un transistor de transfert. La tension accumulée par la photodiode pendant une période d'intégration peut être transférée au noeud de détection par l'intermédiaire du transistor de transfert.

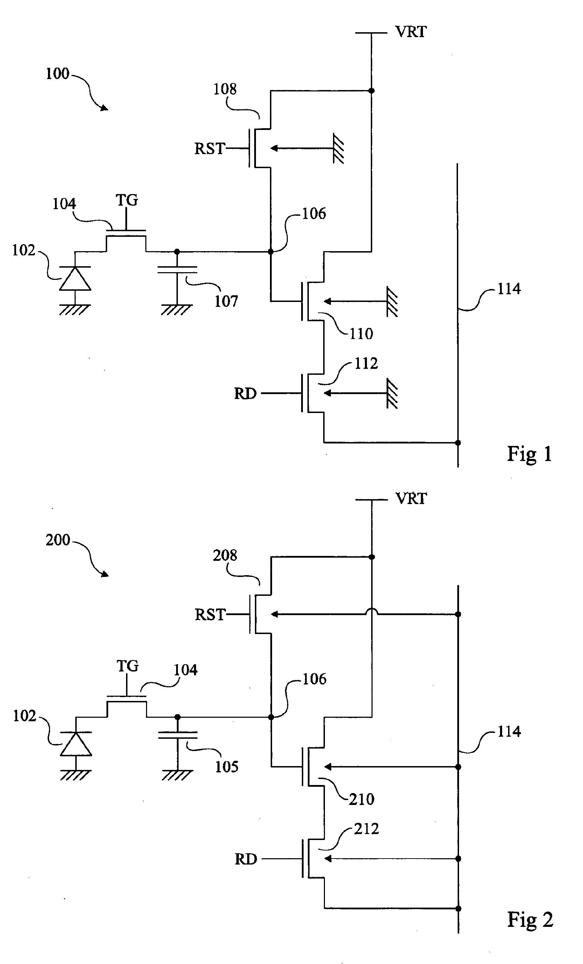

La figure 1 représente un circuit de pixel 100 d'un capteur d'image comprenant une photodiode 102 couplée par un transistor de transfert 104 à un noeud de détection 106. Le noeud de détection 106 a une capacité 107 qui est par exemple formée des capacités parasites des composants environnants, etc. Le noeud de détection 106 est couplé à une tension d'alimentation VRT par l'intermédiaire d'un transistor de remise à zéro 108 qui reçoit un signal de remise à zéro RST sur sa grille et a son contact de caisson connecté à la masse. Le noeud de détection 106 est également couplé au noeud de grille d'un transistor à source suiveuse 110 dont le drain est couplé à la tension d'alimentation VRT et le contact de caisson (parfois également appelé contact de substrat) est connecté à la masse. Le noeud de source du transistor à source suiveuse 110 est couplé par un transistor de lecture 112 à une ligne de sortie 114 du circuit de pixel 100. Le transistor de lecture reçoit sur sa grille un signal de lecture RD et a également son contact de caisson couplé à la masse.

Pour améliorer la qualité d'image d'un capteur d'image comprenant un réseau de circuits de pixels tels que celui de la figure 1, il existe un besoin d'amélioration de la sensibilité du circuit de pixel.

La demande de brevet US 2004/036009 correspond à un procédé et dispositif pour la réduction du courant obscur dans un dispositif CMOS de capture d'image.

La demande de brevet US 2002/196352 correspondant à une matrice d'amplificateur à source suiveuse.

Résumé de l'invention

Un objet de modes de réalisation de la présente invention est de traiter partiellement au moins un ou plusieurs des besoins de l'art antérieur.

Selon un aspect de la présente invention, il est prévu un circuit de pixel d'un capteur d'image comprenant un noeud de détection pour mémoriser une charge transférée à partir d'une ou plusieurs photodiodes ; et un transistor à source suiveuse dont la grille est couplée au noeud de détection et la source est couplée à une ligne de sortie du circuit de pixel par l'intermédiaire d'un transistor de lecture, dans lequel le contact de caisson du transistor à source suiveuse est connecté à la ligne de sortie.

Selon un mode de réalisation de la présente invention, le transistor à source suiveuse et le transistor de lecture sont formés dans un même caisson, le contact de caisson étant connecté à la ligne de sortie.

Selon un mode de réalisation de la présente invention, le caisson est entouré d'un isolement à tranchées peu profondes.

Selon un mode de réalisation de la présente invention, le caisson est entouré d'un isolement à tranchées profondes.

Selon un mode de réalisation de la présente invention, le contact de caisson du caisson est formé au voisinage de la source du transistor de lecture.

Selon un mode de réalisation de la présente invention, le circuit de pixel comprend en outre un transistor de remise à zéro couplé entre le noeud de détection et une tension d'alimentation, et la grille du transistor de remise à zéro est disposée pour recevoir une tension de remise à zéro et le contact de caisson du transistor de remise à zéro est connecté à la ligne de sortie.

Selon un mode de réalisation de la présente invention, le transistor de remise à zéro est formé dans le même caisson que le transistor à source suiveuse et le transistor de lecture.

Selon un mode de réalisation de la présente invention, le noeud de détection est couplé à une ou plusieurs photodiodes par l'intermédiaire d'un ou plusieurs transistors de transfert.

Selon un mode de réalisation de la présente invention, le capteur d'image comprend un réseau de circuits de pixels.

Selon un autre aspect de la présente invention, il est prévu un dispositif électronique comprenant le capteur d'image ci-dessus.

Selon un autre aspect de la présente invention, il est prévu un procédé de fabrication d'un circuit de pixel d'un capteur d'image comprenant les étapes consistant à former un transistor à source suiveuse dont la grille est couplés à un noeud de détection et la source est couplée à une ligne de sortie du circuit de pixel par l'intermédiaire d'un transistor de lecture ; et former une connexion entre le contact de caisson du transistor à source suiveuse et la ligne de sortie.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1, décrite précédemment, illustre schématiquement un circuit de pixel ;
la figure 2 illustre schématiquement un circuit de pixel selon un mode de réalisation de la présente invention ;
la figure 3A représente, en vue de dessus, le circuit de pixel de la figure 2 selon un mode de réalisation de la présente invention ;
la figure 3B est une vue en coupe du circuit de pixel de la figure 3A selon un mode de réalisation de la présente invention ;
la figure 3C est une vue en coupe du circuit de pixel de la figure 3A selon une variante de réalisation de la présente invention ; et
la figure 4 représente schématiquement un dispositif électronique selon un mode de réalisation de la présente invention.

Description détaillée

La figure 2 représente un circuit de pixel 200, qui a de nombreuses parties communes avec le circuit de pixel 100 de la figure 1 et dans lequel de mêmes caractéristiques ont été désignées par de mêmes références. Toutefois, dans le circuit de pixel 200, le transistor de remise à zéro 108, le transistor à source suiveuse 110 et le transistor de lecture 112 ont été remplacés par un transistor de remise à zéro 208, un transistor à source suiveuse 210 et un transistor de lecture 212, respectivement. Le transistor à source suiveuse 210, et optionnellement également les transistors de remise à zéro et de lecture 208, 212, ont un contact de caisson couplé à la ligne de colonne de sortie 114. En particulier, plutôt que d'avoir des contacts de caisson couplés à la masse, le contact de caisson d'au moins le transistor à source suiveuse 210 est couplé à la ligne de sortie 114.

Les inventeurs ont découvert que l'effet de caisson du transistor à source suiveuse limite son gain et réduit ainsi le facteur de conversion de charge en tension de colonne (CVF) du transistor à source suiveuse. Le gain A du transistor à source suiveuse, égal au changement de tension de son noeud de source divisé par le changement de tension de son noeud de grille, $\Delta VS/\Delta VG$, peut être déterminé par :

$$A = \frac{1}{1 + \frac{\gamma}{2\sqrt{\phi_B - V_{BS}}}}$$

où $\gamma$ est égal à $((2q\varepsilon_{si}N_A)^{1/2})/c_{ox}$, dans lequel q est la charge élémentaire de l'électron, $\varepsilon_{si}$ est la permittivité relative du silicium, $N_A$ est la densité d'accepteurs dans la grille, $C_{OX}$ est la capacité de l'oxyde de grille par unité de surface, $\phi_B$ est le potentiel de surface égal à 2(kT/q)ln(NA/Ni), où k est la constance de Boltzmann, T est la température, $N_A$ est la densité des accepteurs dans la grille, Ni est la concentration de porteurs intrinsèques, et $V_{BS}$ est la différence de tension entre le caisson et la source.

Pour obtenir un gain A proche de l'unité, la tension $V_{BS}$ doit être basse, de préférence très voisine de zéro, et être constante. Les inventeurs ont découvert que ceci peut être obtenu en couplant le caisson à la ligne de sortie du pixel, étant donné que la ligne de sortie fournit un niveau de tension qui suit de près la tension de source du transistor à source suiveuse.

Dans des variantes de réalisation, les contacts de caisson du transistor de remise à zéro 208 et/ou du transistor de lecture 212 pourraient être couplés à une tension de référence telle que la masse, ou à leurs noeuds de source respectifs.

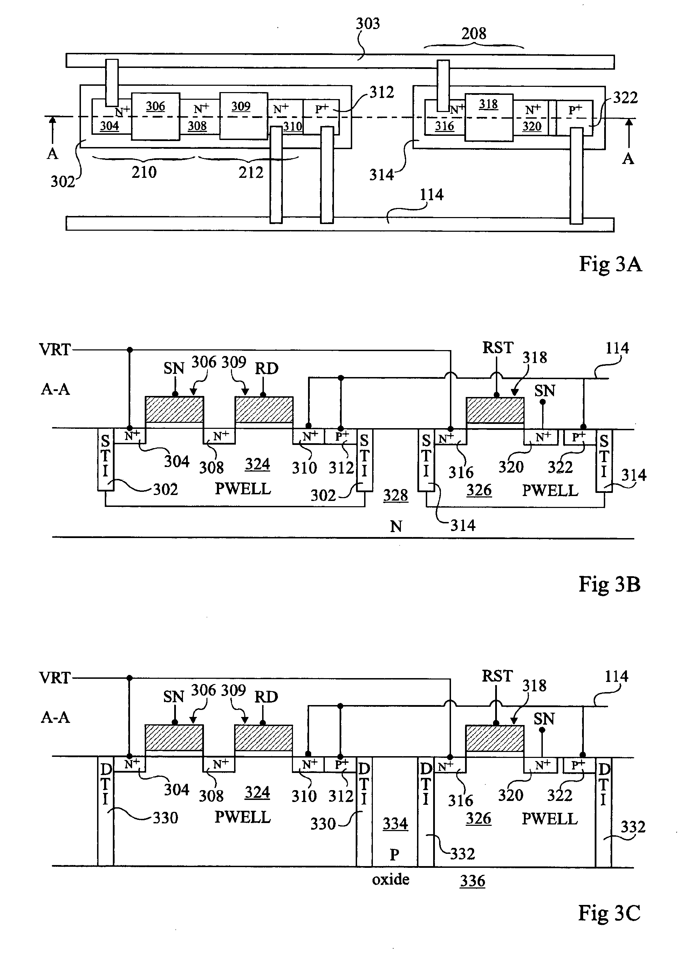

La figure 3A est une vue de dessus représentant un exemple de topologie des trois transistors 210, 212 et 208 de la figure 2. Le transistor à source suiveuse 210 et le transistor de lecture 212 sont formés dans un même caisson entouré par un isolement à tranchée peu profonde (STI) 302. Le drain du transistor à source suiveuse 210 est formé d'une région 304 fortement dopée de type N connectée à un rail d'alimentation 303. L'empilement de grille est désigné par la référence 306. La source du transistor 210 et le drain du transistor de lecture 212 sont constitués d'une région fortement dopée de type N 308. Le transistor de lecture 212 comprend en outre un empilement de grille 309 et une source constituée d'une région 310 fortement dopée de type N qui est connectée à la ligne de sortie 114. Dans le caisson du transistor à source suiveuse 210 et du transistor de lecture 212, un contact de caisson 312 est constitué d'une région fortement dopée de type P disposée près de la source 310. Le contact de caisson 312 est connecté à la ligne de sortie 114.

Dans un caisson séparé entouré d'un isolement à tranchées peu profondes (STI) 314, le transistor de remise à zéro 208 comporte un drain constitué d'une région fortement dopée de type N 316 couplée au rail d'alimentation 303, un empilement de grille 318 et une source constituée d'une région 320 fortement dopée de type N. Un contact de caisson du transistor de remise à zéro 208 est constitué d'une région 322 fortement dopée de type N disposée le long de la région de source 320 mais séparée de celle-ci par une zone non implantée.

La figure 3B est une vue en coupe selon le plan A-A de la figure 3A, représentant la tranchée d'isolement peu profonde (STI) 302 entourant le caisson P 324 des transistors 210 et 212, et la tranchée STI 314 entourant le caisson P 326 du transistor de remise à zéro 208. Les caissons P 324 et 326 sont formés dans un substrat de type N 328. Comme cela est représenté, le contact de source 310 et le contact de caisson 312 sont par exemple formés de façon adjacente et en contact, étant donné que ces contacts sont tous deux connectés à la même tension sur la ligne de sortie.

La figure 3C est une vue en coupe selon le plan A-A de la figure 3A selon une variante de réalisation par rapport à la figure 3B. Dans la coupe de la figure 3C, les isolements à tranchées peu profondes (STI) 302, 314 sont remplacés par des isolements à tranchées profondes (DTI) 330, 332, qui s'étendent sur toute la profondeur des caissons P 324, 326, qui dans cet exemple sont formés sur toute l'épaisseur de la couche de type P 334 disposée au-dessus d'un isolement d'oxyde sous-jacent 336.

Dans une variante de réalisation des figures 3A, 3B et 3C, un caisson unique pourrait contenir les trois transistors 210, 212, 208 et un ou plusieurs contacts de caisson pourraient être prévus dans ce caisson pour le relier à une sortie 114.

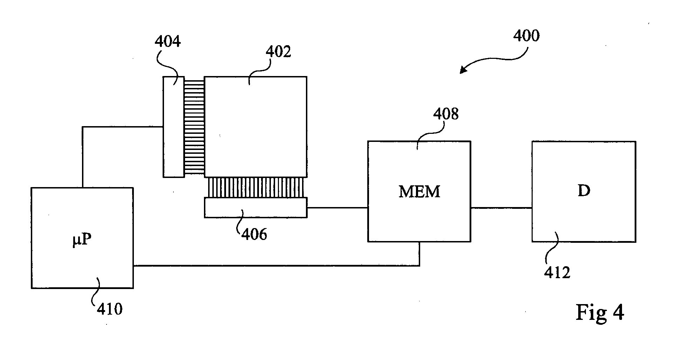

La figure 4 représente un dispositif électronique 400 comprenant un capteur d'image 402 comprenant un réseau de pixels connecté à des circuits de pixels dont chacun a une structure telle que décrite précédemment en relation avec les modes de réalisation des figures 2, 3A, 3B ou 3C. Un circuit de commande 404 fournit des signaux de commande pour le capteur d'image 402, en particulier des tensions de transfert TG, des tensions de remise à zéro RST et des tensions de lecture RD aux circuits de pixels. Un circuit de colonne 406 est prévu pour détecter et mémoriser temporairement la tension de sortie de chaque circuit de pixel et mémoriser les données d'image dans une mémoire 408 sous la commande d'un microprocesseur 410. Un affichage 412 permet d'afficher les images mémorisées dans la mémoire 408.

Le dispositif électronique 400 est par exemple un appareil photographique et/ou une caméra vidéo numérique, un dispositif mobile ou une console de jeu portable pouvant capter des images, une caméra adaptée à fonctionner sur Internet, un ordinateur ou autre dispositif de capture d'images numériques comprenant un capteur d'image adapté à capter des images fixes et/ou mobiles.

Un avantage du couplage du contact de caisson du transistor à source suiveuse à la ligne de sortie est que ceci fournit une amélioration notable sur le facteur de conversion de charge en tension de colonne, ce qui fournit un rapport signal/bruit plus élevé et donc une sensibilité accrue du capteur d'image et donc une meilleure qualité d'image. Par exemple, on a observé qu'un gain typique du transistor à source suiveuse d'environ 0,75 % peut être amélioré de plus de 25 % pour l'amener très près de 1.

En outre, en couplant le contact de caisson du transistor à source suiveuse et du transistor de lecture à la ligne de sortie, ces transistors peuvent avantageusement être formés dans un même caisson.

Bien que la présente invention ait été décrite en relation avec divers modes de réalisation particuliers, il sera clair pour l'homme de l'art que diverses variantes et modifications peuvent être utilisées.

Par exemple, alors que le circuit de pixel de la figure 2 comprend une seule photodiode, à titre de variante des photodiodes multiples pourraient être prévues dont chacune est couplée au noeud de détection 106 par un transistor de transfert correspondant. En outre, l'invention peut s'appliquer à d'autres circuits de pixels dans lesquels un transistor à source suiveuse a son noeud de source couplé à une ligne de sortie par un transistor de lecture.

En outre, les modes de réalisation décrits ici peuvent s'appliquer à une grande gamme de capteurs d'images, incluant des capteurs d'images munis de photodiodes et/ou des transistors à source suiveuse avec un isolement par jonction, un isolement à tranchées profondes ou peu profondes ou un isolement d'oxyde.

En outre, alors que les transistors à source suiveuse, les transistors de remise à zéro et les transistors de lecture sont dans les modes de réalisation décrits des transistors MOS à canal N, un ou plusieurs de ces transistors pourraient être remplacés par un transistor MOS à canal P.

## Revendications

1. Capteur d'image comprenant un circuit de pixel comprenant :

   un noeud de détection (106) pour mémoriser une charge transférée à partir d'une ou plusieurs photodiodes (102) ; et
   un transistor à source suiveuse (210) dont la grille est couplée au noeud de détection et la source est couplée à une ligne de sortie (114) du circuit de pixel par l'intermédiaire d'un transistor de lecture (212), **caractérisé en ce que** :

      le contact de caisson du transistor à source suiveuse est connecté à la ligne de sortie (114).

2. Capteur d'image selon la revendication 1, dans lequel le transistor à source suiveuse et le transistor de lecture sont formés dans un même caisson (324), le contact de caisson (312) étant connecté à la ligne de sortie.

3. Capteur d'image selon la revendication 2, dans lequel le caisson (324) est entouré d'un isolement à tranchées peu profondes (302).

4. Capteur d'image selon la revendication 2, dans lequel le caisson (324) est entouré d'un isolement à tranchées profondes (330).

5. Capteur d'image selon l'une quelconque des revendications 2 à 4, dans lequel le contact de caisson (312) du caisson (324) est formé au voisinage de la source du transistor de lecture.

**6.** Capteur d'image selon l'une quelconque des revendications 2 à 5, le circuit de pixel comprenant en outre un transistor de remise à zéro (208) couplé entre le noeud de détection et une tension d'alimentation, dans lequel la grille du transistor de remise à zéro est disposée pour recevoir une tension de remise à zéro (RST) et le contact de caisson (322) du transistor de remise à zéro est connecté à la ligne de sortie.

**7.** Capteur d'image selon la revendication 6, dans lequel le transistor de remise à zéro est formé dans le même caisson que le transistor à source suiveuse et le transistor de lecture.

**8.** Capteur d'image selon l'une quelconque des revendications 1 à 7, dans lequel le noeud de détection est couplé à une ou plusieurs photodiodes par l'intermédiaire d'un ou plusieurs transistors de transfert (104).

**9.** Capteur d'image selon l'une quelconque des revendications 1 à 8, comprenant un réseau de circuits de pixels.

**10.** Dispositif électronique comprenant le capteur d'image de l'une quelconque des revendications 1 à 9.

**11.** Procédé de fabrication d'un circuit de pixel d'un capteur d'image comprenant :

former un transistor à source suiveuse (210) dont la grille est couplée à un noeud de détection et la source est couplée à une ligne de sortie (114) du circuit de pixel par l'intermédiaire d'un transistor de lecture (212) ; et **caractérisé en ce que** le procédé comprend :

former une connexion entre le contact de caisson du transistor à source suiveuse et la ligne de sortie (114).

**Patentansprüche**

**1.** Ein Bildsensor, der eine Pixel-Schaltung aufweist, die folgendes aufweist:

einen Abfühlknoten (106) zum Speichern einer von einer oder mehreren Fotodioden (102) übertragenen Ladung; und
ein Source-Folger-Transistor (210), dessen Gate mit dem Abfühlknoten verbunden ist und dessen Source mit einer Ausgangsleitung (114) der Pixelschaltung verbunden ist, und zwar über einen Lesetransistor (212), **dadurch gekennzeichnet, dass** ein Körperkontakt des Source-Folger-Transistors verbunden ist mit der erwähnten Ausgangsleitung (114).

**2.** Der Bildsensor nach Anspruch 1, wobei der erwähnte Source-Folger-Transistor und der erwähnte Lesetransistor in einer gleichen Vertiefung (324) geformt sind, wobei der Körperkontakt (312) der erwähnten Vertiefung mit der erwähnten Ausgangsleitung verbunden ist.

**3.** Der Bildsensor nach Anspruch 2, wobei die Vertiefung (324) durch eine flache Grabenisolierung (302) umgeben ist.

**4.** Der Bildsensor nach Anspruch 2, wobei die Vertiefung (324) von einer tiefen Grabenisolierung (330) umgeben ist.

**5.** Der Bildsensor nach einem der Ansprüche 2 bis 4, wobei der Körperkontakt (312) der erwähnten Vertiefung (324) benachbart zu einer Source des Lesetransistors geformt ist.

**6.** Der Bildsensor nach einem der Ansprüche 2 bis 5, wobei die Pixelschaltung ferner einen Rücksetztransistor (208) aufweist, und zwar verbunden zwischen dem Abfühlknoten und einer Versorgungsspannung, wobei das Gate des Rücksetztransistors angeordnet ist zum Empfang einer Rücksetzspannung (RST) und wobei ferner ein Körperkontakt (322) des Rücksetztransistors mit der erwähnten Ausgangsleistung verbunden ist.

**7.** Der Bildsensor nach Anspruch 6, wobei der Rücksetztransistor in der gleichen Vertiefung wie der Source-Folger-Transistor und der Lesetransistor geformt ist.

**8.** Der Bildsensor nach einem der Ansprüche 1 bis 7, wobei der Sensorknoten mit der einen oder mehreren Fotodioden gekoppelt bzw. verbunden ist, und zwar über einen oder mehrere Übertragungstransistoren (104).

**9.** Der Bildsensor nach einem der Ansprüche 1 bis 8, der eine Anordnung aus Pixelschaltungen aufweist.

**10.** Eine elektronische Vorrichtung, die einen Bildsensor nach einem der Ansprüche 1 bis 9 aufweist.

**11.** Ein Verfahren zur Herstellung einer Pixelschaltung eines Bildsensors, wobei folgendes vorgesehen ist:

Formen eines Source-Folger-Transistors (210) mit seinem Gate gekoppelt bzw. verbunden mit einem Sensorknoten und mit seiner Source gekoppelt bzw. verbunden mit einer Ausgangsleitung (114) der Pixelschaltung über einen Lesetransistor (212); und

**dadurch gekennzeichnet, dass** das Verfahren folgendes aufweist:

Formen einer Verbindung zwischen einem Körperkontakt des Source-Folger-Transistors und der Ausgangsleitung (114).

## Claims

1. An image sensor comprising a pixel circuit comprising:

   a sense node (106) for storing a charge transferred from one or more photodiodes (102); and a source follower transistor (210) having its gate coupled to the sense node and its source coupled to an output line (114) of the pixel circuit via a read transistor (212), **characterized in that**:

   a body contact of the source follower transistor is connected to said output line (114).

2. The image sensor of claim 1, wherein said source follower transistor and said read transistor are formed in a same well (324), the body contact (312) of said well being connected to said output line.

3. The image sensor of claim 2, wherein said well (324) is surrounded by a shallow trench isolation (302).

4. The image sensor of claim 2, wherein said well (324) is surrounded by a deep trench isolation (330).

5. The image sensor of any of claims 2 to 4, wherein the body contact (312) of said well (324) is formed adjacent to a source of said read transistor.

6. The image sensor of any of claims 2 to 5, the pixel circuit further comprising a reset transistor (208) coupled between the sense node and a supply voltage, wherein the gate of the reset transistor is arranged to receive a reset voltage (RST) and a body contact (322) of the reset transistor is connected to said output line.

7. The image sensor of claim 6, wherein said reset transistor is formed in the same well as the source follower transistor and read transistor.

8. The image sensor of any of claims 1 to 7, wherein said sense node is coupled to the one or more photodiodes via one or more transfer transistors (104).

9. The image sensor of any of claims 1 to 8, comprising an array of pixel circuits.

10. An electronic device comprising the image sensor of any of claims 1 to 9.

11. A method of manufacturing a pixel circuit of an image sensor comprising:

    forming a source follower transistor (210) having its gate coupled to a sense node and its source coupled to an output line (114) of the pixel circuit via a read transistor (212); and **characterized in that** the method comprises:

    forming a connection between a body contact of the source follower transistor and the output line (114).

VRT
100
108
RST
104
TG
106
102
107
110
114
112
RD
Fig 1
VRT
200
208
RST
TG
104
106
102
105
114
210
212
RD
Fig 2

303
208
N+
306
N+
309
N+
P+
312
322
318
N+
P+
304
308
310
316
320
A
A
302
210
212
314
114

Fig 3A

VRT
A-A
SN
306
309
RD
RST
318
114
SN
N+
N+
N+
P+
N+
N+
P+
STI
STI
STI
STI
304
308
324
310
312
316
320
322
314
302
PWELL
302
328
326
PWELL
N
314

Fig 3B

VRT
A-A
SN
306
309
RD
RST
318
114
SN
N+
N+
N+
P+
N+
N+
P+
DTI
DTI
DTI
DTI
304
308
324
310
312
316
320
322
330
PWELL
330
334
326
PWELL
332
P
332
oxide
336

Fig 3C

404
402
400
408
MEM
D
μP
406
412
410
Fig 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 2004036009 A
- US 2002196352 A